(19) Europäisches Patentamt
European Patent Office
Office européen des brevets

(11) Veröffentlichungsnummer: **0 315 851 B1**

(12) **EUROPÄISCHE PATENTSCHRIFT**

(45) Veröffentlichungstag der Patentschrift: **03.06.92**

(51) Int. Cl.$^5$: **B32B 15/08**

(21) Anmeldenummer: **88118077.2**

(22) Anmeldetag: **31.10.88**

(54) **Verbundmaterial aus hochtemperaturbeständigen Polymeren und direkt darauf aufgebrachten Metallschichten.**

(30) Priorität: **07.11.87 DE 3737922**

(43) Veröffentlichungstag der Anmeldung:
**17.05.89 Patentblatt 89/20**

(45) Bekanntmachung des Hinweises auf die Patenterteilung:
**03.06.92 Patentblatt 92/23**

(84) Benannte Vertragsstaaten:
**CH DE FR GB IT LI NL**

(56) Entgegenhaltungen:
**EP-A- 0 089 387**
**EP-A- 0 116 297**
**EP-A- 0 184 368**
**EP-A- 0 189 913**

(73) Patentinhaber: **BASF Aktiengesellschaft**
**Carl-Bosch-Strasse 38**
**W-6700 Ludwigshafen(DE)**

(72) Erfinder: **Buchert, Hermann, Dr.**
**An der Nolzeruhe 8 c**
**W-6702 Bad Duerkheim(DE)**
Erfinder: **Grimm, Gerhard**
**Am Horren 4**
**W-6701 Altrip(DE)**
Erfinder: **Muenstedt, Helmut, Dr.**
**An dem Altenbach 41**
**W-6706 Wachenheim(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services

## Beschreibung

Die Erfindung betrifft Verbundmaterialien, im wesentlichen aufgebaut aus

A: einem hochtemperaturbeständigen Thermoplasten A auf der Basis von Polyarylethersulfonen, Polyaryletherketonen, Polyetherimiden oder thermotropen Polymeren und

B: einer direkt darauf aufgebrachten metallischen Kupferschicht B, deren Oberfläche durch chemische Behandlung vergrößert wurde,

wobei die Seite mit vergrößerter Oberfläche dem hochtemperaturbeständigen Thermoplasten zugewandt ist und die Haftfestigkeit zwischen der metallischen Schicht B) und dem hochtemperaturbeständigen Thermoplasten A), gemessen bei einer Abzugsgeschwindigkeit von 20 mm/min und einem Abzugswinkel von 180°, mindestens 1,9 N/mm beträgt.

Zur Herstellung von Leiterplatten werden heute überwiegend Trägermaterialien auf der Basis von Epoxyharzen verwendet, auf die die Leiterplatten nach einem Ätzverfahren aufgebracht sind. Da derartige Harze nicht thermoplastisch verarbeitbar sind, ist die Herstellung solcher Platten wie auch deren Formgebung relativ zeit- und kostenaufwendig.

Leiterplatten auf der Basis von thermoplastischen Polymeren weisen diese Nachteile nicht auf, doch treten bei deren Herstellung Probleme auf. So bereitet es Schwierigkeiten, die metallischen Leiterbahnen mit einer ausreichenden Haftfestigkeit auf den thermoplastischen Träger aufzubringen; darüber hinaus muß der thermoplastische Träger auch ausreichend wärmebeständig sein, um den beim Befestigen der Bauteile auf der Leiterplatte erforderlichen Lötvorgang unbeschadet zu überstehen.

Aus der EP-B 63 347 ist ein Verfahren zur Aufbringung von elektrisch leitenden Kupferbahnen auf Thermoplaste bekannt, bei dem eine Kupferfolie, welche mit einer Haftschicht versehen ist, mit Hilfe eines beheizten Klischees auf den Thermoplasten gepreßt wird. Auf dem Klischee sind die gewünschten Leiterbahnen erhaben angebracht, so daß beim Preßvorgang die gewünschten Leiterbahnen abgeschert und durch die zwischen Kupferfolie und Substrat angeordnete Haftschicht mit dem Substrat verklebt wird. Nicht benötigte Kupferfolie wird mit Hilfe einer Trägerfolie, die auf der der Haftschicht gegenüberliegenden Seite der Kupferfolie aufgebracht ist, abgezogen.

Dieses Verfahren erfordert zum einen eine mindestens aus 3 Schichten (Haftschicht, eigentliche Kupferfolie und Trägerfolie) bestehende Kupferfolie und zum anderen sind die maximalen Klischeetemperaturen auf 220-230°C begrenzt, da sowohl die Haftschicht als auch die Trägerfolie bei höheren Temperaturen beschädigt werden.

Darüber hinaus muß die Haftschicht auf jeden einzelnen Thermoplasten abgestimmt werden; mit hochtemperaturbeständigen Thermoplasten wie Polyarylethersulfonen, Polyaryletherketonen und Polyetherimiden werden keine zufriedenstellenden Ergebnisse erzielt.

Aus der EP-A-189 913 ist bekannt, eine vorher oberflächlich oxidierte und dann wieder reduzierte Kupferfolie auf - vor allem duroplastische-Werkstoffe unter Druck und Wärme aufzubringen.

Aufgabe der vorliegenden Erfindung war es daher, Verbundmaterialien aus hochtemperaturbeständigen Thermoplasten und Kupfer zur Verfügung zu stellen, die auf einfache Weise herstellbar sind und eine ausreichende Haftfestigkeit zwischen Kupferschicht und Thermoplast aufweisen.

Erfindungsgemäß wird diese Aufgabe durch ein Material gelöst, wie es erhalten wird, wenn man die Kupferschicht in Form einer Folie mit einer durch chemische Oxidation auf einer Seite vergrößerten Oberfläche mit dieser Seite mit einer Preßvorrichtung auf den Thermoplasten bei einem Druck von 50 kPa bis 2 MPa aufpreßt, wobei die Temperatur des Preßwerkzeugs im Bereich von 15 bis 60°C oberhalb der Glasübergangstemperatur des hochtemperaturbeständigen Thermoplasten A liegt.

Als Bestandteil A enthalten die erfindungsgemäßen Verbundmaterialien einen hochtemperaturbeständigen Thermoplasten auf der Basis von Polyarylethersulfonen, Polyaryletherketonen, Polyetherimiden oder thermotropen, d.h. flüssig-kristallinen Polymeren.

Es versteht sich, daß auch Mischungen verschiedener Polymerer der vorstehend genannten Typen sowie Copolymere aus Einheiten, die sich von verschiedenen Monomeren, die die einzelnen Polymerarten aufbauen, ableiten. Diese Copolymeren können die Einheiten in statistischer Anordnung oder in Blockform enthalten.

Hochtemperaturbeständige Thermoplaste, die sich im wesentlichen aus Einheiten der allgemeinen Formel I und/oder II ableiten, sind eine erste bevorzugte Gruppe, wobei der Anteil an Einheiten der Formeln I und II jeweils 0 - 100 mol% betragen kann, d.h. keiner besonderen Beschränkung unterliegt.

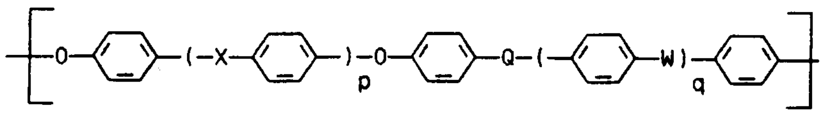

(I)

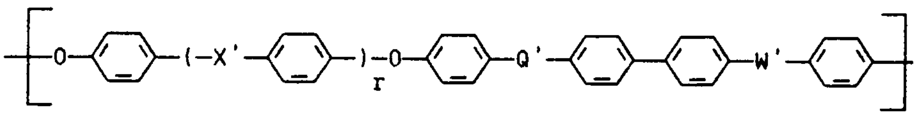

(II)

oder deren kernsubstituierte $C_1$-$C_6$-Alkyl- oder Alkoxy, Aryl-, Chlor- oder Fluorderivate, wobei X, X′, Q, Q′ W und W′ unabhängig voneinander -$SO_2$-, -O-, -S-, -CO- eine chem. Bindung oder -CRR′- sein können, R und R′ jeweils Wasserstoffatome, $C_1$-$C_6$-Alkyl- oder Alkoxygruppen, Arylgruppen oder deren Fluor- oder Chlorderivate darstellen, und p, q und r jeweils den Wert 0 oder 1 haben.

Unter diese Definition fallen in Abhängigkeit von der Bedeutung der Substituenten X, Q, W, X′, Q′ und W′ sowohl Polyarylethersulfone als auch Polyaryletherketone sowie deren Copolymere mit statistischem oder blockartigem Aufbau.

Als eine Gruppe bevorzugter Beispiele für Einheiten der Formeln I und II seien aufgeführt:

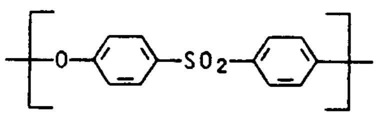

(I1)

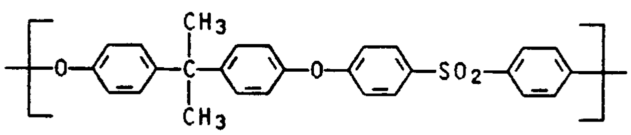

(I2)

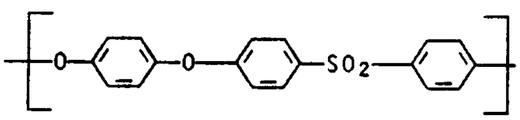

(I3)

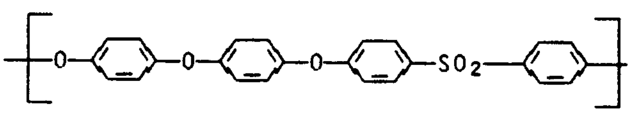

(I4)

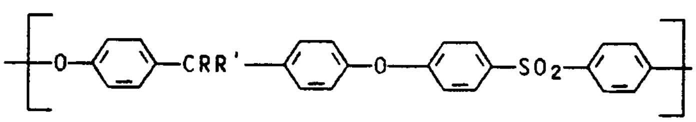

(I5)

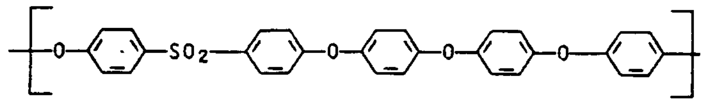

(I6)

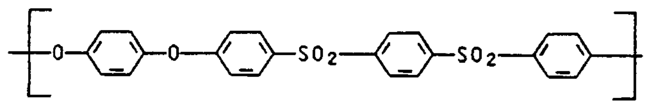

(I7)

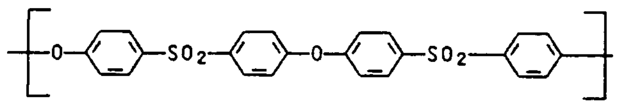

(I8)

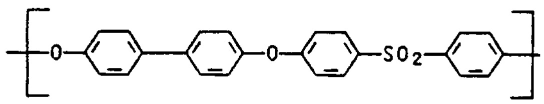

(I9)

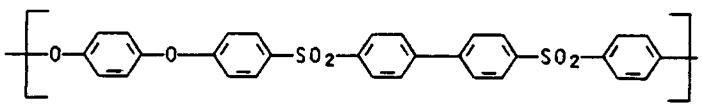

(II1)

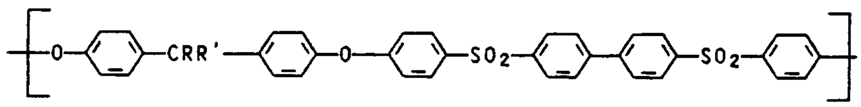

(II2)

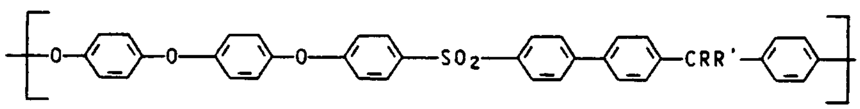

(II3)

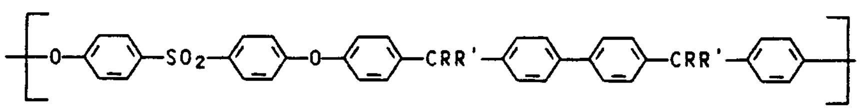

(II4)

und

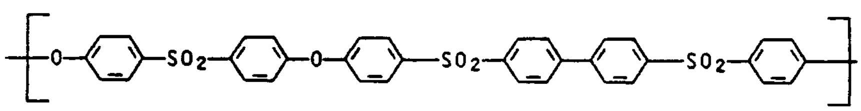

(II5)

Über die Substituenten X, Q, W bzw. X′, Q′ und W′ und die Parameter p, q und r lassen sich die vorstehenden Beispiele wie folgt beschreiben:

| | p | q | X | Q | W |
|---|---|---|---|---|---|
| I1 | 1 | 0 | $-SO_2-$ | $SO_2$ | - |
| I2 | 1 | 0 | $-C(CH_3)_2-$ | $-SO_2-$ | - |
| I3 | 0 | 0 | - | $-SO_2-$ | - |
| I4 | 1 | 0 | -O- | $-SO_2-$ | - |
| I5 | 1 | 0 | -CRR'- | $-SO_2-$ | - |
| I6 | 1 | 1 | $-SO_2-$ | -O- | -O- |
| I7 | 0 | 1 | - | $-SO_2-$ | $-SO_2-$ |
| I8 | 1 | 0 | $-SO_2-$ | $-SO_2-$ | - |
| I9 | 1 | 0 | chem. Bdg. | $-SO_2-$ | - |

| | r | X' | Q' | W' |
|---|---|---|---|---|
| II1 | 0 | - | $-SO_2-$ | $-SO_2-$ |
| II2 | 1 | -CRR'- | $-SO_2-$ | $-SO_2-$ |
| II3 | 1 | -O- | $-SO_2-$ | -CRR'- |
| II4 | 1 | $-SO_2-$ | -CRR'- | -CRR'- |
| II5 | 1 | $-SO_2-$ | $-SO_2-$ | $-SO_2-$ |

Obwohl, wie bereits erwähnt, grundsätzlich beliebige Kombinationen der Substituenten X, Q und W bzw. X' , Q' und W' möglich sind, werden im allgemeinen solche Einheiten bevorzugt, in denen Q und W bzw. Q' und W' gleich sind, da die entsprechenden Monomeren in der Regel leichter zugänglich sind.

Besonders bevorzugt als Komponente A) sind Polyarylethersulfone, die 50 bis 100 mol-% an wiederkehrenden Einheiten der Formel 11, 12 und 115 aufweisen.

Die Komponente A) kann - wie bereits erwähnt - auch mehrere verschiedene Einheiten der allgemeinen Formel I enthalten, d.h. sie kann ein Copolymer mit statistischem oder blockweisem Aufbau sein.

Durch teilweisen oder vollständigen Ersatz der $SO_2$-Gruppen in den vorstehend dargestellten Formeln durch CO-Gruppen gelangt man zu Polyaryletherketonen bzw. zu Sulfon/Keton-Copolymeren. Verfahren zur Herstellung derartiger Produkte sind allgemein bekannt, weshalb sich hier nähere Angaben erübrigen.

Das Molekulargewicht derartiger Polymerer (Zahlenmittelwert) liegt im allgemeinen im Bereich von 2 000 bis 150 000, vorzugsweise von 4 000 - 70 000.

Monomere, aus denen sich die Einheiten der allgemeinen Formeln I und II herstellen lassen, sind beispielsweise

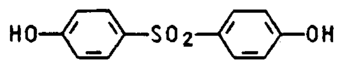

4,4'-Dihydroxydiphenylsulfon

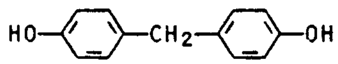

Di-(4-hydroxyphenyl)methan

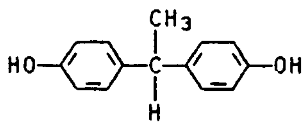

2,2-Di(4-hydroxyphenyl)ethan

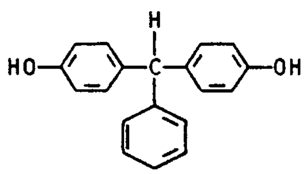

1-Phenyl-1,1-di-(4-hydroxyphenyl)-methan

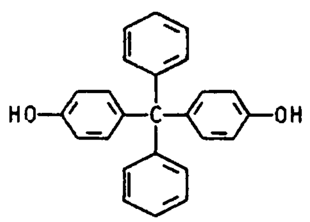

Diphenyl-di-(4-hydroxyphenyl)methan

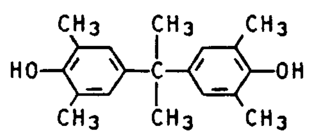

Tetramethylbisphenol A

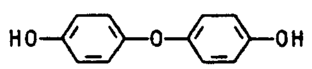

4,4'-Dihydroxydiphenylether

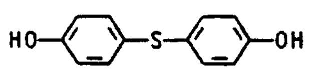

4,4'-Dihydroxydiphenylsulfid

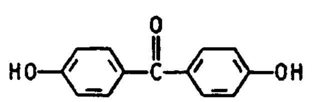

4,4'-Dihydroxybenzophenon

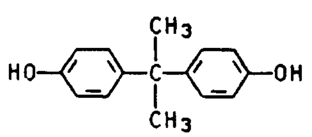

Bisphenol A

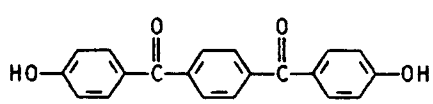

1,4-Di(4-hydroxybenzoyl)benzol

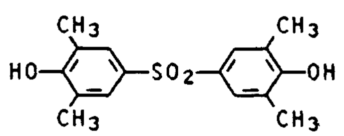

3,3',5,5'-Tetramethyl-4,4'-dihydroxy-diphenylsulfon

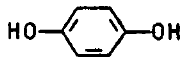

Hydrochinon

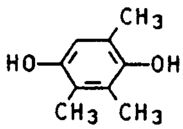

2,3,6-Trimethylhydrochinon

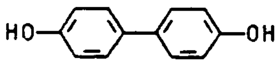

4,4'-Dihydroxydiphenyl

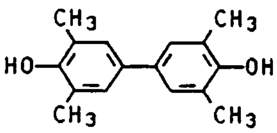

3,3',5,5'-Tetramethyldihydroxydiphenyl

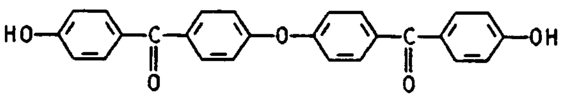

Dihydroxybenzophenonether

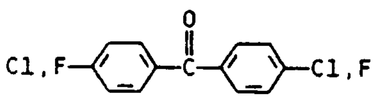

4,4'-Dichlorbenzophenon

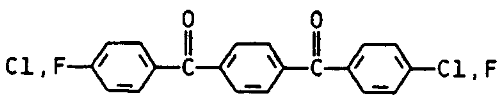

1,4-Di(4-chlorbenzoyl)benzol

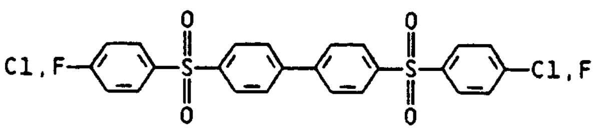

4,4'-Di-(4-chlorphenylsulfonyl)-diphenyl

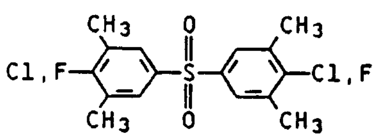

3,3',5,5'-Tetramethyl-4,4'-dichlordiphenylsulfon

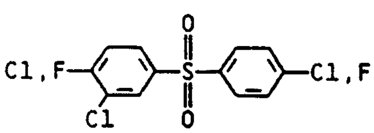

3'-Chlor-4,4'-Dichlordiphenylsulfon

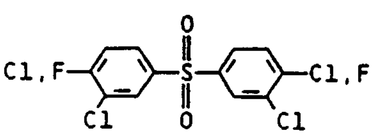

3,3',4,4'-Tetrachlordiphenylsulfon

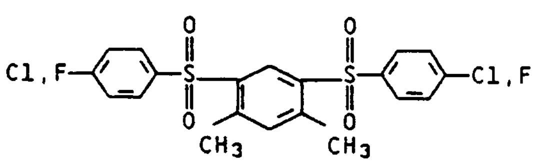

1,5-Dimethyl-2,4-di(4'-chlorphenylsulfonyl)benzol

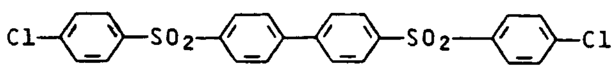

4,4'-Di(4-chlorphenyl-sulfonyl)biphenyl

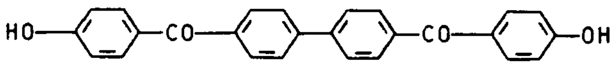

4,4'-Di(4-hydroxy-benzoyl)-biphenyl

Für einige Anwendungszwecke hat es sich als vorteilhaft erwiesen, wenn die Polyarylethersulfone bzw. Polyaryletherketone einen Alkalimetallgehalt von weniger als 100 ppm aufweisen. Derartige Produkte sind durch entsprechende Aufarbeitungsverfahren erhältlich.

Eine weitere Gruppe geeigneter hochtemperaturbeständiger Thermoplaste sind Polyetherimide, die neben Ethergruppierungen Imidstrukturen in den wiederkehrenden Einheiten aufweisen. Entsprechende Produkte sind z.T. bereits kommerziell im Handel erhältlich, z.B. Ultem® der General Electric Company, welches folgende wiederkehrenden Einheiten enthält:

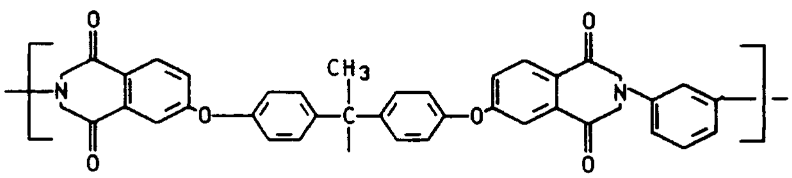

(I6)

Entsprechende Produkte, wie auch Verfahren zu deren Herstellung werden z.B. in der US-A 3 847 867 (entspricht der DE-A 23 63 785) und der DE-A 24 37 286 beschrieben, worauf hier wegen näherer Einzelheiten verwiesen wird.

Als letzte Gruppe hochtemperaturbeständiger Thermoplaste A) sind die thermotropen Polymeren zu nennen, d.h. Polymere, die eine anisotrope Schmelzphase bilden. Nähere Angaben sind den einschlägigen Standardwerken zu entnehmen, die auf diesem Gebiet bekannt sind, z.B. A. Blumstein (Hrsg), "Liquid Crystalline Order in Polymers" um nur eines dieser Werke zu nennen. Auch in einer Vielzahl von Patentanmeldungen werden solche Polymere beschrieben, wobei hier nur beispielsweise auf die EP-A 226 839, EP-A 226 078, EP-A 225 539, EP-A 230 551, EP-A 226 847, EP-A 230 545, EP-A 230 546, EP-A 226 080, EP-A 227 947, EP-A 230 547, EP-A 225 537, EP-A 225 529, EP-A 231 642, EP-A 230 550, und die EP-A 231 468 verwiesen sei.

Die hochtemperaturbeständigen Polymeren werden zur Herstellung der erfindungsgemäßen Verbundmaterialien vorzugsweise in Form von Platten oder Folien mit einer Dicke von 0,03-5 mm eingesetzt. Es sind jedoch prinzipiell auch andere Formen möglich, solange die metallische Schicht noch auf einfache Weise, vorzugsweise mit einem Preßwerkzeug aufgebracht werden kann.

Die hochtemperaturbeständigen thermoplastischen Polymeren A) können gegebenenfalls bis zu 90, vorzugsweise 1-60 und insbesondere 2-50 Gew.%, bezogen auf das Gesamtgewicht an thermoplastischen Polymeren und Füllstoff, an faser- oder teilchenförmigen Füllstoffen enthalten, wobei die Füllstoffe vorzugsweise Isolatoren oder zumindest schlechte elektrische Leiter sind.

Als Beispiele seien Glasfasern, Glaskugeln, Quarzmehl, Wollastonit, Kreide (Calciumcarbonat) und Bornitrid genannt.

Als Komponente B) enthalten die erfindungsgemäßen Verbundmaterialien eine direkt - ohne Haftschicht oder andere Haftvermittler - aufgebrachte Kupferschicht, welches auf der dem thermoplastischen Polymeren zugewandten Seite chemisch behandelt wurde und dadurch eine vergrößerte Oberfläche aufweist.

Vergrößerung der Oberfläche durch chemische Behandlung läßt sich durch Oberflächenoxidation erzielen. Geeignete Oxidationsmittel hängen vom Typ des verwendeten Kupfers ab und sind dem Fachmann bekannt, so daß sich hier nähere Angaben erübrigen.

Diese einseitige Oxidation der Kupferschicht ist wesentlich für die Haftfestigkeiten zwischen Metall und Thermoplast von mehr als 1,9 N/mm, vorzugsweise mehr als 1,95 N/mm und insbesondere mehr als 2,0 N/mm.

Neben dem Maximalwert der Haftfestigkeit ist in der Praxis auch die Gleichmäßigkeit der Haftung der Metallschicht B) auf dem Thermoplasten A) von Bedeutung, d.h. daß nicht nur an einzelnen Punkten eine besonders hohe Haftfestigkeit erreicht werden sollte, sondern die Metallschicht B) über einen Großteil der Fläche, mit welcher sie mit dem Thermoplasten verbunden ist, gute bis sehr gute Haftfestigkeiten aufweist.

Eine Möglichkeit, Anhaltspunkte über diesen Parameter zu erhalten, wird nachstehend an Hand der Figur erläutert.

Die Figur zeigt ein Kraft-Weg-Diagramm, welches man erhält, wenn man die zum Abziehen der Metallschicht vom Thermoplasten erforderliche Kraft in Abhängigkeit vom Ort auf dem erfindungsgemäßen Verbundmaterial, an dem die Kraft gemessen wird, aufträgt.

Aus dem Maximum dieser Kurve erhält man bei bekannter Abzugsbreite die maximale Haftfestigkeit in N/mm und als Maßzahl für die Gleichmäßigkeit der Haftung kann die Fläche unter der Kurve herangezogen werden, welche zur Gesamtfläche des Rechtecks CDEF ins Verhältnis gesetzt wird. Dabei entspricht der Punkt D dem Schnittpunkt der Tangente an die Kurve parallel zur x-Achse mit der y-Achse und der Punkt E entspricht dem Schnittpunkt der vorstehenden Geraden mit der Geraden parallel zur y-Achse, die durch den Punkt auf der x-Achse gezogen wird, an dem die Abzugskraft den Wert 0 erreicht, d.h. die Metallschicht vollständig vom Thermoplasten abgezogen ist.

Punkt C entspricht dem Ursprung des gewählten Koordinatensystems und Punkt F entspricht dem Schnittpunkt der Kraft-Weg-Kurve mit der x-Achse, d.h. F kennzeichnet den Punkt, an dem die Metallschicht vollständig abgezogen ist.

Man erkennt, daß der Idealfall dann erreicht ist, wenn die Fläche unter der gemessenen Kraft-Weg-Kurve mit der des Rechtecks CDEF identisch ist und daß die Gleichmäßigkeit der Haftung umso besser ist, je größer das Verhältnis der Fläche unter der Kraft-Weg-Kurve zur Fläche des Rechtecks CDEF ist.

Bei den erfindungsgemäßen Verbundmaterialien beträgt dieses Verhältnis vorzugsweise mindest 0,6 bzw. 60 %, insbesondere mindestens 0,7 (70 %) und liegt besonders bevorzugt im Bereich von 0,70 bis 0,95.

Die Dicke der Kuperfolien leigt im allgemeinen im Bereich von 5 bis 500 µm, vorzugsweise von 8 bis 350 µm und insbesondere von 12 bis 250 µm. Als besonders geeignet haben sich bislang Foliendicken von 15 - 50 µm herausgestellt.

Die Folie wird auf das hochtemperaturbeständige Polymer vorzugsweise mit einem Preßwerkzeug aufgebracht, wobei sich in Abhängigkeit vom verwendeten thermoplastischen Polymeren unterschiedliche Bedingungen (Temperatur des Preßwerkzeugs, Druck beim Pressen) als vorteilhaft herausgestellt haben.

Das erfindungsgemäße Verbundmaterial wird bevorzugt nach dem nachstehend beschriebenen Verfahren hergestellt.

Nach diesem Verfahren wird eine einseitig oxidierte Kupferfolie mit einem Preßwerkzeug auf ein Trägermaterial aus hochtemperaturbeständigen thermoplastischen Polymeren aufgebracht, wobei die Temperatur des Preßwerkzeugs im Bereich von 15 bis 60° C, vorzugsweise von 20 bis 50° C, insbesondere von 25 bis 40° C, oberhalb der Glasübergangstemperatur des Thermoplasten liegt und die oxidierte Seite der Folie mit dem Thermoplasten verbunden wird; liegt die Temperatur außerhalb dieses Bereichs so werden (bei zu niedrigen Temperaturen) keine ausreichenden Haftfestigkeiten erhalten bzw. es ist eine Deformation des Trägermaterials (Blasenbildung bei zu hohen Temperaturen) und damit einhergehend, ebenfalls eine Verschlechterung der Haftfestigkeit festzustellen.

Der Druck beim Preßvorgang liegt im Bereich von 50 kPa (0,5 bar) bis 2 MPa (20 bar), wobei die optimalen Werte vom verwendeten Trägermaterial und der Temperatur des Preßwerkzeugs abhängen. Bevorzugt liegt der Druck im Bereich von 100-1 000, insbesondere von 200-800 kPa.

Die Dauer des Preßvorgangs ist ebenfalls variierbar und liegt im allgemeinen im Bereich von 3-240 sec, vorzugsweise von 5-120 sec. und insbesondere von 10-60 sec. , wiederum abhängig von der Art des Trägermaterials, dem Preßdruck und der Oberflächentemperatur des Werkzeugs.

Dabei entfält die Verwendung eines Klebers zur Aufbringung der Kupferfolie mit allen damit verbundenen Problemen, ohne daß die Haftfestigkeit beeinträchtigt wird.

Darüber hinaus ist keine Erwärmung des thermoplastischen Trägermaterials an sich mehr erforderlich; die über die erhöhte Temperatur des Preßwerkzeugs eingebrachte Wärme reicht aus.

Es können sowohl ganzfläching mit Kupfer beschichtete Thermoplaste als auch direkt Leiterplatten hergestellt werden. Im ersten Fall kann als Preßwerkzeug ein beliebiger Stempel verwendet werden, im letzteren Fall werden vorzugsweise Klischees benutzt, auf denen die Leiterbahnen erhaben angebracht sind.

Obwohl noch nicht eindeutig gesichert, deuten erste Erkenntnisse darauf hin, daß die Oxidation und die damit einhergehende Oberflächenvergrößerung der Kupferschicht in Verbindung mit der optimalen Temperatur-Druck-Kombination für die hervorragenden Haftfestigkeiten verantwortlich sind. Aufgrund ihrer guten Eigenschaften eignen sich die erfindungsgemäßen Verbundmaterialien besonders als Leiterplatten auf dem elektrotechnischen und elektronischen Sektor, aber auch zur Herstellung von Kupferbeschichteten Formteilen ganz allgemein.

Beispiele

Eine einseitig oxidierte Kupferfolie mit einer Dicke von 35 µm wurde mit einem Stempel bei einem Druck von 500 kPa und Stempeloberflächentemperaturen von 230 bis 270 ° C auf eine 1,6 mm dicke Platte aus einem Polyethersulfon mit wiederkehrenden Einheiten der Formel

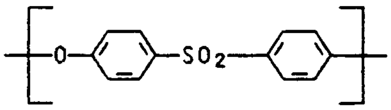

(Ultrason® E 2000 der BASF AG, Glasübergangstemperatur 226 ° C) bei Preßzeiten von 20 sec. aufgepreßt.

An den so erhaltenen Materialien wurde die Haftfestigkeit bei einer Abzugsgeschwindigkeit von 20 mm/min und einem Abziehwinkel von 180 ° bestimmt.

Ebenfalls angegeben ist das Verhältnis der Fläche unter der so ermittelten Kraft-Weg-Kurve zur Fläche des Rechtecks CDEF wie in der Figur definiert.

In den Beispielen 10 - 16 enthielt das Polyethersulfon 20 Gew.% Glasfasern.

Tabelle

| Bsp.-Nr. | Temp. des Preßwerkzeugs °C | max. Haftfestigkeit N/mm | Flächenverhältnis [%] |
|---|---|---|---|
| 1 | 230 | 1,9 | 37,1 |
| 2 | 235 | 1,9 | 51,7 |
| 3 | 240 | 1,9 | 48,2 |
| 4 | 245 | 1,9 | 68,3 |
| 5 | 250 | 1,95 | 86,9 |
| 6 | 255 | 2,0 | 86,8 |
| 7 | 260 | 2,0 | 85,9 |
| 8 | 265 | 1,95 | 82,8 |
| 9 | 270 | 1,95 | 74,6 |
| 10 | 230 | 1,9 | 39,6 |
| 11 | 235 | 1,92 | 58,3 |
| 12 | 240 | 1,9 | 63,5 |
| 13 | 245 | 1,95 | 70,9 |
| 14 | 250 | 1,95 | 68,0 |
| 15 | 255 | 1,98 | 79,5 |
| 16 | 260 | 2,0 | 86,0 |

Man erkennt, daß durch die Verpressung im Bereich von 15 bis 45 ° C oberhalb der Glasübergangstempertur des Thermoplasten besonders vorteilhafte Ergebnisse erzielt werden, insbesondere im Hinblick auf die Gleichmäßigkeit der Haftfestigkeit. Bei den maximalen Haftfestigkeiten ist die Abhängigkeit von der Preßtemperatur nicht so stark ausgeprägt.

**Patentansprüche**

**1.** Verbundmaterial, im wesentlichen aufgebaut aus

A: einem hochtemperaturbeständigen Thermoplasten A auf der Basis von Polyarylethersulfon, Polyaryletherketon, Polyetherimid oder einem thermotropen Polymeren und

B: einer direkt darauf aufgebrachten metallischen Kupferschicht, deren Oberfläche vor dem Aufbringen durch chemische Oxidation vergrößert worden ist,

wobei die Seite mit vergrößerter Oberfläche dem hochtemperaturbeständigen Thermoplasten zugewandt ist und die Haftfestigkeit zwischen der Kupferschicht B und dem Thermoplasten A, gemessen bei einer Abzugsgeschwindigkeit von 20 mm/min und einem Abzugswinkel von 180°, mindestens 1,9 N/mm beträgt, wie es erhalten wird, wenn man die Kupferschicht in Form einer Folie mit einer durch chemische Oxidation auf einer Seite vergrößerten Oberfläche mit dieser Seite mit einer Preßvorrichtung auf den Thermoplasten bei einem Druck von 50 kPa bis 2 MPa aufpreßt, wobei die Temperatur des Preßwerkzeugs im Bereich von 15 bis 60°C oberhalb der Glasübergangstemperatur des hochtemperaturbeständigen Thermoplasten A liegt.

**2.** Verbundmaterial nach Anspruch 1, dadurch gekennzeichnet, daß der hochtemperaturbeständige Thermoplast A) aufgebaut ist aus

0 bis 100 mol-% Einheiten der allgemeinen Formel I

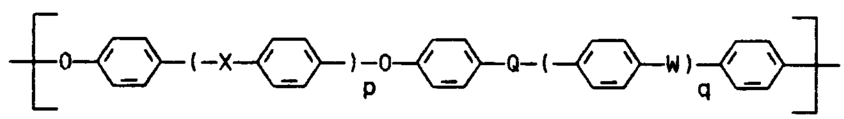

(I)

und/oder
0 bis 100 mol-% Einheiten der allgemeinen Formel

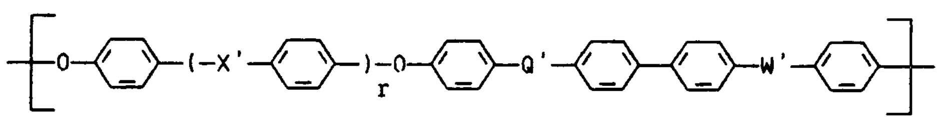

(II)

oder deren kernsubstituierten $C_1$-$C_6$-Alkyl- oder Alkoxy, Aryl-, Chlor- oder Fluorderivaten, wobei X, X', Q, Q' W und W' unabhängig voneinander
-$SO_2$-, -O-, -S-, -CO- eine chem. Bindung oder -CRR′- sein können, R und R′ jeweils Wasserstoffatome, $C_1$-$C_6$-Alkyl- oder Alkoxygruppen, Arylgruppen oder deren Fluor- oder Chlorderivate darstellen, und p, q und r jeweils den Wert 0 oder 1 haben.

**3.** Verbundmaterial nach den Ansprüchen 1 und 2, dadurch gekennzeichnet, daß das thermoplastische Polymer A) bis zu 90 Gew.%, bezogen auf das Gesamtgewicht an thermoplastischem Polymer und Füllstoff eines faser-oder teilchenförmigen Füllstoffs oder deren Mischungen enthält.

**Claims**

**1.** A laminate essentially composed of

A: a thermoplastic A which is stable at high temperatures and is based on polyaryl ether sulfone, polyaryl ether ketone, polyether imide or a thermotropic polymer and

B: a metallic copper layer which is applied directly to the said polymers and whose surface area has been increased by chemical oxidation prior to this application,

the side having an increased surface area facing the thrermoplastic which is stable at high temperatures, and the adhesion between the copper layer B and the thermoplastic A being not less than 1.9 N/mm, measured at a peeling speed of 20 mm/min and a peeling angle of 180°, as is obtained when the copper layer in the form of a foil, having a surface area which has been increased on one side by chemical oxidation, is pressed with this side onto the thermoplastic using a press under from 50 kPa to

2 MPa, the temperature of the press tool being from 15 to 60 ° C above the glass transition temperature of the thermoplastic A which is stable at high temperatures.

**2.** A laminate as claimed in claim 1, wherein the thermoplastic A) which is stable at high temperatures is composed of
from 0 to 100 mol % of units of the formula I

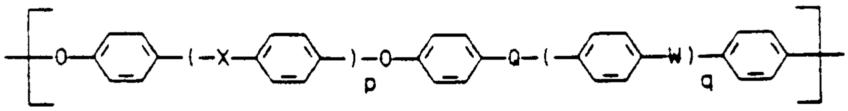

(I)

and/or
from 0 to 100 mol % of units of the formula

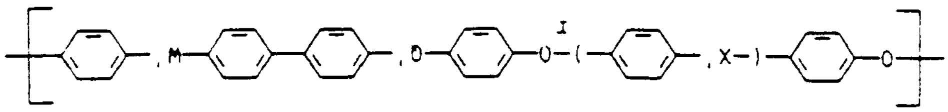

(II)

or their ring-substituted $C_1$-$C_6$-alkyl or alkoxy, aryl, chorine or fluorine derivatives, where X, X', Q, Q', W and W' independently of one another are each -$SO_2$-, -O-, -S- or -CO-, a chemical bond or -CRR'-, R and R' are each hydrogen, $C_1$-$C_6$-alkyl or alkoxy, aryl or their fluorine or chlorine derivatives, and p, q and r are each 0 or 1.

**3.** A laminate as claimed in claims 1 and 2, wherein the thermoplastic polymer A) contains up to 90% by weight, based on the total weight of the thermoplastic polymer and filler, of a fibrous or particulate filler or of a mixture of these.

**Revendications**

**1.** Matériau composite, conistitué essentiellement par

A. une matière thermoplastique A résistante à haute température, à base de polyaryléthersulfone, de polyaryléthercétone, de polyétherimide ou d'un polymère thermotrope, et

B. une couche de cuivre métallique qui est appliquée directement par-dessus et dont la surface a été augmentée par oxydation chimique avant l'application,

la face dont la surface est augmentée étant tournée vers la matière thermoplastique résistante à haute température et l'adhérence entre la couche de cuivre B et la matière thermoplastique A, mesurée à une vitesse de pelage de 20 mm/mn et avec un angle de pelage de 180 ° C, s'élevant au moins à 1,9 N/mm, tel qu'il est obtenu lorsqu'on presse la couche de cuivre, sous la forme d'une feuille ayant une surface augmentée par oxydation chimique sur l'une de ses faces, par cette face sur la matière thermoplastique au moyen d'un dispositif de pressage sous une pression de 50 kPa à 2 MPa, la température de l'outil de pressage se situant dans la gamme de 15 à 60 ° C au-dessus de la température de transition vitreuse de la matière thermoplastique A résistante à haute température.

**2.** Matériau composite selon la revendication 1, caractérisé en ce que la matière thermoplastique A) résistante à haute température est composée de O à 100% en moles de motifs de formule générale I

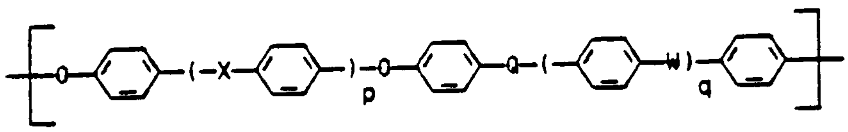

(I)

et/ou

de 0 à 100% en moles de motifs de formule générale

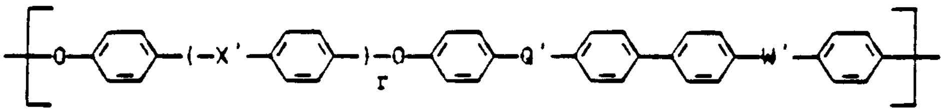

(II)

ou de leurs dérivés substitués sur les noyaux par des groupements alkyle ou alcoxy en $C_1$-$C_6$, aryle ou des atomes de chlore ou de fluor, X, x', Q, Q', W et W' pouvant être mis, indépendamment les uns des autres, pour $-SO_2-$, -O-, -S-, -CO-, une liaison chimique ou -CAR'-, R et R' représentant respectivement des atomes d'hydrogène, des groupements alkyle ou alcoxy en $C_1$-$C_6$, des groupements aryle ou leurs dérivés fluorés ou chlorés, et p, q et r ayant chacun la valeur 0 ou 1.

**3.** Matériau composite selon la revendication 1 ou 2, caractérisé en ce que le polymère thermoplastique A) contient jusqu'a 90% en poids, par rapport au poids total de polymère thermoplastique et de matière de charge, d'une matière de charge en forme de fibres, de particules ou de mélange de celles-ci.

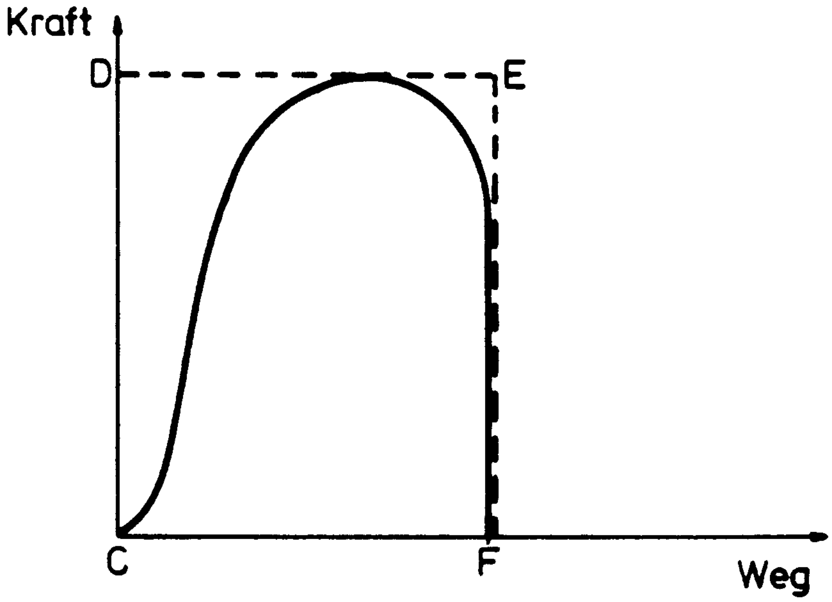
Kraft
D
E
C
F
Weg